# EUROPEAN PATENT APPLICATION

(11) **EP 4 703 750 A1**
(43) Date of publication of application: **04.03.2026**
(21) Application number: 24306414.4
(22) Date of filing: 30.08.2024
(51) Int. Cl.: G01R 31/392, G01N 24/00, H01M 10/48, G01N 21/00, G01N 22/00, G01N 27/72, G01R 31/382, H02J 7/00

(54) **MONITORING DEVICE AND METHOD FOR MONITORING A BATTERY**

(71) Applicant: TOYOTA JIDOSHA KABUSHIKI KAISHA, Aichi-ken, 471-8571 (JP)
(72) Inventor: PLACE, Vadim, 1140 BRUSSELS (BE); KINGE, Sachin, 1140 BRUSSELS (BE); CASTRO, Laurent, 1140 BRUSSELS (BE)
(74) Representative: Cabinet Beau de Loménie

(57) **Abstract**

A monitoring device for monitoring a battery cell comprising:
- at least one quantum sensor (8) configured to be arranged in a battery cell (1),
- an irradiation source (5, 6, 7) configured to provide excitation to the at least one quantum sensor (8),
- an optical detector (4) configured to receive irradiation emitted by the at least one quantum sensor (8) in reaction to said excitation,
- a Quantum Sensor Controller unit (3) configured to control the irradiation source (5, 6, 7) and measure an Electron Paramagnetic Resonance frequency shift of the at least one quantum sensor (8) as a function of the irradiation received by the optical detector (4),
- a processing unit configured to calculate data representative of at least one physical parameter of the battery cell (1) as a function of the measured Electron Paramagnetic Resonance frequency shift, the processing unit being further configured to calculate a State Of Health of the battery cell (1) as a function of said data representative of at least one physical parameter of the battery cell (1).

## Description

### BACKGROUND OF THE INVENTION

### 1. Field of the invention

The present disclosure relates to the state monitoring on electrochemical devices such as batteries, and specifically to a monitoring device for monitoring a battery cell and method for monitoring a battery cell.

### 2. Description of Related Art

Long lasting and reliable battery devices are needed for various applications in electric mobility as well as stationary energy storage. For such energy storage systems, it is important to monitor the State Of Health (SoH) of the device. SoH is a parameter generally understood as a gauge of the degradation of the battery over time. SoH can be defined as the instant state (t) of the battery as well as its state relative to time (t-dt) or relative to a reference value. SoH refers to the condition and performance of the device as a whole or of the individual components of the device.

SoH can be estimated from parameters such as, for example, temperature fluctuations of the device, internal resistance for example by applying a known current and voltage, strain in the materials of the device, current, voltage measurements, cycle count or other parameters.

Monitoring SoH of the batteries is especially important for vehicles as this allows a more predictable use and helps to maximize the cycle of life of the battery.

Survey of the battery is also important to ensure a safe use of said battery as a battery failure could lead to dangerous situations for the user. SoH of the battery is monitored through measured physical parameters of the battery such as the temperature, current or strain.

Non-destructive methods known to estimate SoH of the battery can include, for examples, electrochemical measurements (Electrochemical Impedance Spectroscopy (EIS), Incremental capacity analysis (ICA) and differential voltage analysis (DVA) technique), current/capacity measurements (capacity tests, ohmic internal resistance tests), temperature measurements (thermal imaging, Impedance-based temperature measurements, Johnson noise thermometry, thermo-resistive, thermo-junctive, Fiber Bragg Grating), etc.

However, the spatial accuracy of known methods is limited by the number of sensing elements on the devices. For instance, for a Fiber Bragg Grating Sensor, the number of temperature sensing elements is limited by the number of signals that can be multiplexed onto one single optical fiber, and is, in any case, limited by the length of the optical fiber.

The spatial resolution of the known technologies is severely limited by the number of devices and/or sensors that it is possible to insert inside the battery without excessively straining the materials.

Moreover, most of the known methods are dedicated to measurement of temperature and do not allow for the measurement of multiple physical parameters in addition to the temperature. Such parameters could be strain, pressure, or magnetic field.

The measurement of a parameter such as temperature, strain or pressure is possible with Fiber Bragg Grating technology. However, the spatial resolution remains limited and it is not possible to accurately determine the gradient of a physical parameter at a surface of the battery. Moreover, it is not possible to measure multiple parameters at the same location with Fiber Bragg Grating technology as the type of Fiber Bragg Grating is different for each parameter.

Furthermore, many sensors such as thermistors, thermos-resistive devices and Fiber Bragg Gratings are not chemically inert and can cause strain. They can react with the active materials of the battery, and this limits the locations in which they can be placed.

There is a need for a monitoring device for monitoring a battery cell which provides an accurate indication of SoH of the battery cell and other parameters with a good spatial resolution. There is also a need for ensuring safety of the battery. These needs are required regarding any part of the battery, including for parts inside the battery.

### SUMMARY

The invention aims to provides an accurate indication of the SoH of a battery cell with a good spatial resolution. Furthermore, the invention aims to provide a monitoring device for monitoring a battery cell ensuring safety of the battery cell.

The present disclosure provides a monitoring device for monitoring a battery cell comprising:
- at least one quantum sensor configured to be arranged in a battery cell,
- an irradiation source configured to provide excitation to the at least one quantum sensor,
- an optical detector configured to receive irradiation emitted by the at least one quantum sensor in reaction to said excitation,
- a quantum sensor controller unit configured to control the irradiation source and measure an Electron Paramagnetic Resonance frequency shift of the at least one quantum sensor as a function of the irradiation received by the optical detector,
- a processing unit configured to calculate data representative of at least one physical parameter of the battery cell as a function of the measured Electron Paramagnetic Resonance frequency shift, the processing unit being further configured to calculate a State Of Health of the battery cell as a function of said data representative of at least one physical parameter of the battery cell.

Such quantum sensors provide a good spatial resolution for measurement of the battery physical parameters such as temperature, strain, magnetic field, current and pressure sensing in the battery, which leads to a more accurate estimation of the internal SoH of the battery.

Moreover, quantum sensors, such as for instance Nitrogen Vacancy diamonds sensors, allow the measurement of multiple physical parameters such as temperature, current, magnetic field or strain with the same sensing element, i.e. the same quantum sensor. These quantum sensors can be as small as a few nanometers and are chemically inert. Thanks to the small size of such quantum sensors and the chemical inertness of said quantum sensors, said quantum sensors can be dispersed at the surface or inside any active material of the battery cell, allowing improved resolution and therefore an accurate estimation of the SoH. Thanks to these quantum sensors, it is also possible to monitor local concentrations of relevant parameters such as currents, strains and temperatures in the vicinity of the quantum sensors.

According to embodiments of the invention, the monitoring device for monitoring a battery cell can have the following features, alone or in combination.

According to an embodiment, the quantum sensor is a spin sensor. Preferably, the quantum sensor is a Nitrogen Vacancy center Diamond sensor.

According to an embodiment, the source of irradiation comprises a laser, said laser being configured to illuminate the at least one quantum sensor.

According to an embodiment, the source of irradiation comprises a Radiofrequency source, said Radiofrequency source being configured to irradiate the at least one quantum sensor with microwaves.

According to an embodiment, the quantum sensor controller unit is configured to activate the source of irradiation with a defined frequency. This defined frequency is depending on the method used to analyze the optical readout from the at least one quantum sensor. Indeed, irradiation time and frequency can be different according to the frequency measurement methods. As an example, the method used for measuring the transition frequency of particles may be the Ramsey method, the Rabi method, the Hahn-echo sequence or any other method.

According to an embodiment, the quantum sensor controller unit is configured to activate the source of irradiation using a continuous wave spectroscopy method. More specifically, the sensor control unit is configured to activate the laser to provide a continuous illumination to the at least one quantum sensor and to activate the radiofrequency source to irradiate the at least one sensor with continuous microwaves.

According to an embodiment, the sensor control unit is configured to activate the source of irradiation using a pump-probe method. More specifically, the sensor control unit is configured to activate the laser to provide a first illumination irradiation and a second illumination irradiation, the first and second illumination irradiation being spaced apart during a defined period. In an embodiment, the sensor control unit is configured to irradiate the quantum sensor with a first microwave irradiation and a second microwave irradiation, the first and second microwave irradiation being spaced apart during a defined period, the first microwave irradiation starting at the end of the first illumination irradiation and the second illumination irradiation starting at the end of the second microwave irradiation. According to an embodiment, the first and second microwave irradiation have a π/2 µs duration time.

According to an embodiment, the monitoring device further comprises a memory configured to store data calculated by the processing unit for each activation of the source of irradiation.

According to an embodiment, the processing unit is configured to calculate a rate of change of the at least one physical parameter as a function of the stored data, i.e. said at least one physical parameters and the already calculated at least one parameters which are stored in memory, the processing unit being configured to compare said rate of change to a rate of change threshold and change a using parameter of the battery to lower the rate of change below the rate of change threshold if the said rate of change is greater than the rate of change threshold.

According to an embodiment, the processing unit is configured to compare the data representative of at least one physical parameter of the battery with a parameter threshold and to shut down the battery if said data representative of at least one physical parameter is greater than said parameter threshold. This feature ensures safety of the battery by shutting down the battery when the processing unit detects that at least one physical parameter that could lead to a battery failure or a safety problem is above the parameter threshold.

In the present invention, comparison of data representative of the at least one parameter with the threshold depends on the selected parameter. A data representative of the at least one parameter is greater than a parameter threshold if said at least one parameter value is below or above a corresponding threshold value depending on said parameter. As an example, a current output from the battery that is below a current threshold would indicate significant damage to the material which means that the detected current parameter is greater than the current threshold when the detected current output is below the current threshold value. Similarly, a value of strain that is greater than a strain threshold would also indicate large damage to the material which means that the detected strain parameter is greater than the strain threshold when the value of detected strain is above the strain threshold value. In other words, a data representative of the at least one parameter is greater than a parameter threshold if said parameter is below or above a corresponding threshold value for said parameter depending on the at least one parameter.

According to an embodiment, the parameter threshold is a first parameter threshold, the processing unit being configured to compare the data representative of at least one physical parameter of the battery cell to a second parameter threshold, the processing unit being configured to change a usage parameter of the battery to lower the data representative of at least one physical parameter below the second parameter threshold if the data representative of at least one physical parameter is greater than said second parameter threshold. This prevents the battery usage from leading to a failure or a safety problem by reducing the battery usage requirement.

According to an embodiment, the at least one parameter comprises at least one of a temperature, a current or a strain of the battery cell.

The invention also provides a battery cell comprising a monitoring device as described above.

The invention also provides a method for monitoring a battery cell, the method comprising :
- irradiating at least one quantum sensor arranged in the battery cell so as to provide excitation of said at least one quantum sensor;
- receiving irradiation emitted by the at least one quantum sensor resulting from the irradiation of said quantum sensor;
- measuring an Electron Paramagnetic Resonance frequency shift of the at least one quantum sensor;
- calculating data representative of at least one physical parameter of the battery cell as a function of the measured Electron Paramagnetic Resonance frequency shift;
- calculate State Of Health of the battery cell as a function of said data representative of at least one physical parameter of the battery cell.

According to an embodiment, the method for monitoring the battery cell can have the following features, alone or in combination.

According to an embodiment, the method further comprises repeating with a defined frequency the irradiating step, the receiving step the measuring step and the calculating step.

According to an embodiment, irradiation of the quantum sensor comprises illumination of said quantum sensor, for instance thanks to a laser. According to an embodiment, irradiation of the quantum sensor comprises microwave irradiation of said quantum sensor, for instance thanks to a radiofrequency source.

The Electron Paramagnetic Resonance (EPR) frequency shift can be measured according to various methods. According to an embodiment, the Electron Paramagnetic Resonance frequency shift is measured with a continuous wave spectroscopy method. According to an embodiment, the Electron Paramagnetic Resonance frequency shift is measured with a pump-probe method. According to an embodiment, the Electron Paramagnetic Resonance frequency shift is measured with a spin relaxation time measurement of the at least one quantum sensor. As an example, the method used for measuring the transition frequency of particles may be the Ramsey method, the Rabi method, the Hahn-echo sequence or any other method.

According to an embodiment, the method further comprises a step of comparing the data representative of at least one physical parameter to a first parameter threshold. Preferably, the method further comprises a step of shutting down the battery cell if said data representative of at least one physical parameter is greater than said parameter threshold.

According to an embodiment, the method further comprises a step of comparing the data representative of at least one physical parameter to a second parameter threshold. Preferably, the method further comprises a step of changing a usage parameter of the battery cell to lower the data representative of at least one physical parameter below the second parameter threshold if the data representative of at least one physical parameter is greater than said second parameter threshold.

According to an embodiment, the method further comprises the steps of storing in a memory a plurality of calculated data representative of at least one physical parameter of the battery cell, calculating a rate of change of said at least one physical parameter as a function of the calculated data representative of at least one physical parameter and the stored data, i.e. said calculated data representative of at least one physical parameter and already calculated data representative of at least one physical in memory, the method further comprising the step of changing a usage parameter of the battery cell to lower the rate of change below a rate of change threshold if the said rate of change is greater than the rate of change threshold.

According to an embodiment, the battery cell and the monitoring device can have any of the above-described features.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
- FIG. 1 is a diagram schematically showing all elements according to an embodiment of the invention: battery cell comprising a quantum sensor, battery management system, quantum sensor controller, irradiation source and optical detector;
- FIG.2 is a diagram schematically showing the monitoring method using a monitoring device as shown on figure 1;
- FIG. 3 is a graph showing the Electron Paramagnetic Resonance shift from a nitrogen vacancy center diamond using a first measurement method;
- FIG. 4 is a graph showing the Electron Paramagnetic Resonance shift from a nitrogen vacancy center diamond using a second measurement method;
- FIG. 5 is a graph showing the Electron Paramagnetic Resonance shift from a nitrogen vacancy center diamond using a third measurement method.

### DETAILED DESCRIPTION OF EMBODIMENTS

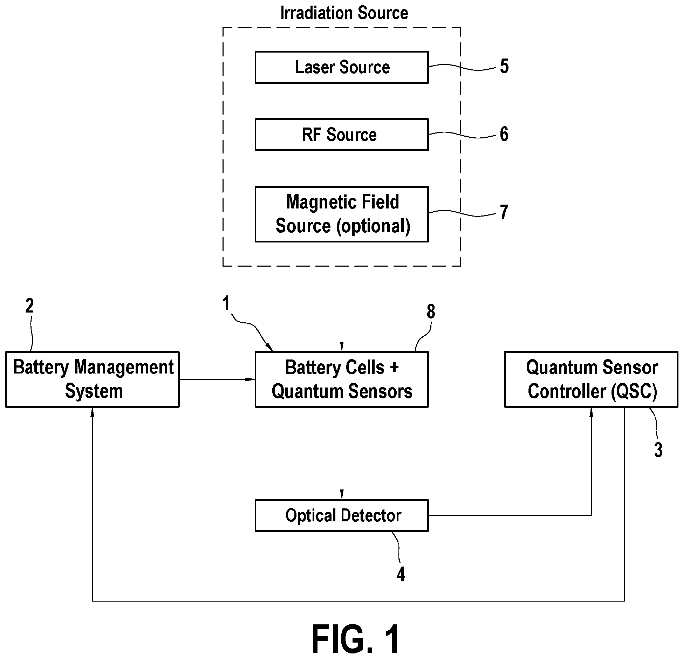

Figure 1 is a diagram schematically showing a monitoring device for monitoring a battery cell 1 according to an embodiment of the invention. In this embodiment, the monitoring device comprises a battery management system 2, a quantum sensor controller unit 3, an optical detector 4, a laser 5, a Radiofrequency source 6, hereafter RF source 6 and a Magnetic Field Source 7.

The monitoring device further comprises a plurality of quantum sensors 8 arranged in the battery cell 1. Said quantum sensors 8 are for instance Nitrogen Vacancy Diamonds sensors, hereafter named NV sensors 8. Such NV sensors 8 comprise at least one NV center which is a point defect in diamond lattice and consists of a substitutional nitrogen atom coupled with an adjacent lattice vacancy in diamond. An NV center can be detected using photoluminescence, the electron spin of the NV center being sensitive to electric field, magnetic field, radiation heat, strain etc. NV sensors 8 can therefore measure different parameters on the NV sensor environment thanks to the changes in the NV center due to external environment.

NV sensors 8 have a very small size, about a few nanometers. For example, it is possible to have NV sensors 8 with an average particle size of 70nm or less, each nanoparticle, or NV sensor 8, containing one or more NV centers. Thanks to this small size, these NV sensors 8 are not space-consuming in the battery cell 1 and can be widely arranged in the battery cell 1.

Moreover, NV sensors 8 are chemically inert and do not react with active material or electrolyte in the battery cell 1. It is possible to embed the quantum sensors, i.e. NV sensors 8, in any bulk or surface material of the battery cell 1 without causing defects or strains to the battery cell 1 components. In other words, NV sensors 8 can be dispersed at the surface or inside any materials of the battery cell 1 without limiting the space available for other components in the battery cell 1 nor negatively react with said other components.

NV sensors 8 dispersion in the battery cell 1 allows probing the physical parameters of any material and/or surface inside the battery cell 1 and measurement of local concentrations of relevant parameters such as currents, strains and/or temperatures. Measurement of said relevant physical parameters of the battery cell 1 using NV sensors 8 dispersion provides an accurate mapping of said physical parameters for any surface in the battery cell 1. In another embodiment, it is also possible to use such an NV sensors 8 dispersion in the battery cell 1 to extract the global value of physical parameters at the cell level by collecting luminescence from one or a plurality of NV sensors 8 in the battery cell, each of said NV sensors 8 comprising one or more NV centers.

As shown on figure 1, the quantum sensor controller unit 3 is configured to control the laser 5 and/or the RF source 6 and/or the Magnetic Field Source 7 to provide excitation to the NV sensors 8 inside the battery cell 1. The optical detector 4 is configured to receive the irradiation emitted by the NV sensors 8 in reaction to said excitation of the NV sensors 8 from the laser 5 and/or the RF source 6 and/or the Magnetic Field Source 7. The quantum sensor controller unit 3 is connected to the optical detector 4 and receives data resulting from the irradiation received by the NV optical detector 4. These data are used in a processing unit included in the quantum sensor controller unit 3. Said processing unit is configured to calculate at least one physical parameter of the battery cell 1 as a function of said data.

The NV sensors 8 can be irradiated in different ways. Similarly, the optical detection from said NV sensor 8 can be read in different ways. For example, if the NV sensor 8 is placed at a surface of a component of the battery cell 1, then irradiation source 5, 6, 7 and the optical detector 4 can be directly arranged at the surface of the NV sensor 8. If the NV sensor is arranged in an active material of the battery cell 1, an irradiation guide and an optical detector guide can be arranged inside the active material to ensure proper irradiation and optical read of the NV sensor 8.

As explained above, the physical parameter can be temperature, current, magnetic field, strain or any other physical parameter in the vicinity of the NV sensors 8 which can be measured thanks to the NV sensors 8 and optical detector 4. The processing unit in the quantum sensor controller unit 3 is configured to calculate the SoH of the battery cell 1 based on said measured physical parameters of the battery cell 1. SoH of the battery cell 1 can be calculated using different methods based on the measured parameters. For instance, article "battery management strategies: an essential review for battery state of health monitoring techniques" by Sunil K. Pradhan and Basab Charkraborty, journal of Energy storage 51 (2022), 104427 recites different methods to calculate the SoH of a battery based on different physical parameters of the battery. However, these methods to calculate SoH remain based on the measured physical parameters. Thanks to the NV sensors 8 used in the battery cell 1 and the quantum sensor controller unit 3 according to the invention, it is possible to accurately calculate the physical parameters of the battery cell 1 with a good mapping resolution which leads to an accurate determination of the SoH of the battery 1.

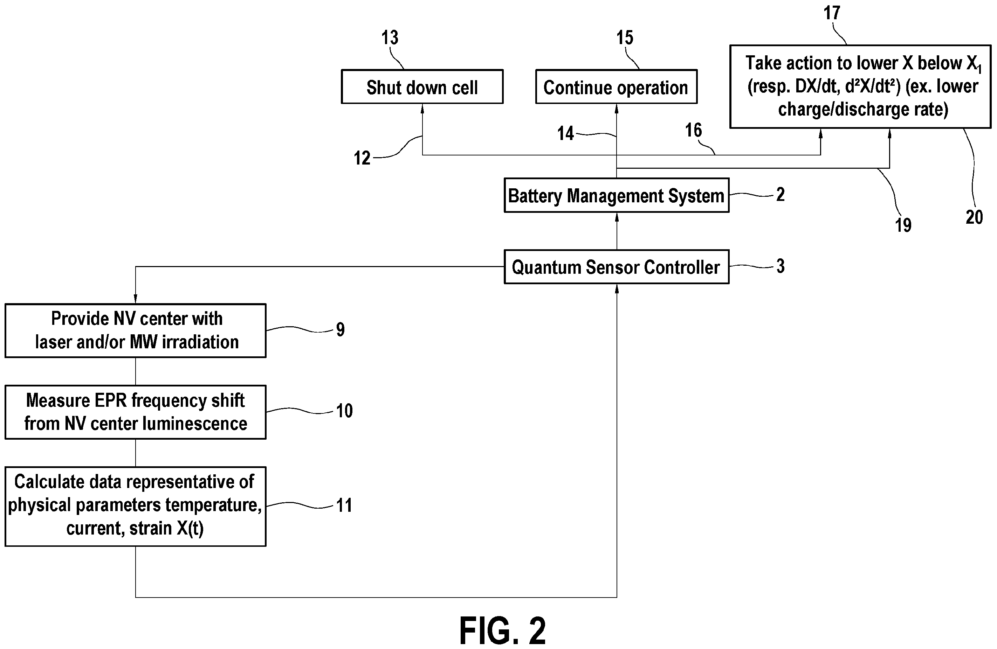

FIG.2 is a diagram schematically showing the monitoring method used for instance in with the battery cell 1 of figure 1. In figure 2, the same element as described above in view of figure 1 have the same reference.

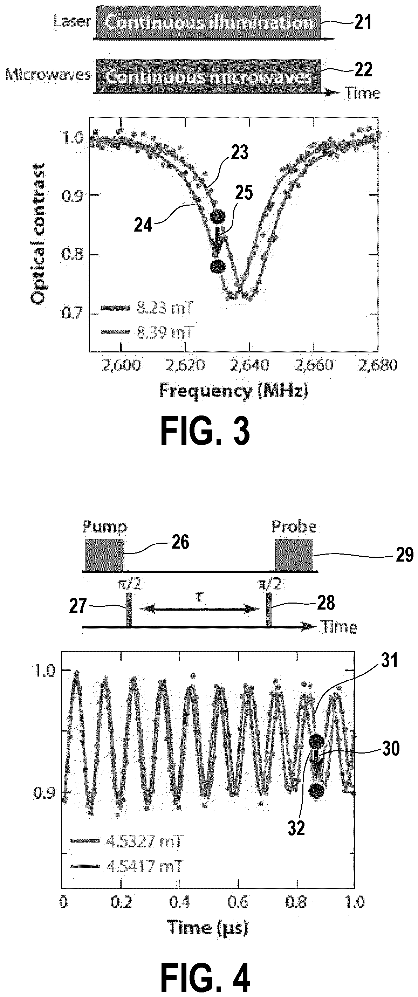

The quantum sensor controller unit 3 is configured to activate the laser 5 and/or the RF source 6 and/or the Magnetic Field Source 7 in order to provide 9 the NV sensor 8 with laser and/or microwave and/or magnetic irradiation. The optical detector 4 sends, to the processing unit included in the quantum sensor controller unit 3, data corresponding to the irradiation measured from the NV sensor 8 in reaction to said irradiation 5,6 or 7. Then, the processing unit in the quantum sensor controller unit 3 measures 10, i.e calculates, at least one Electron Paramagnetic Resonance (EPR) frequency shift from the NV sensor 8 luminescence, as explained below in view of figures 3 to 5. This calculated 10 EPR frequency shift is, or are if a plurality of EPR shifts are required depending on the parameter, used to calculate 11 the physical parameters of the battery cell 1 such as temperature, current or strain.

To ensure the safety or to optimize functioning, lifetime or any relevant parameter of the battery cell 1, calculation 11 of these physical parameters is used to survey the battery cell 1 safety, i.e to track the instant SoH of the battery cell 1. To this end, the quantum sensor controller unit 3 compares data representative of said calculated physical parameters to thresholds. In the embodiment shown on figure 2, the quantum sensor controller unit 3 sends instructions to the battery management system 2 to control the battery cell 1 depending on the result of said comparison.

The comparison between the data representative of the physical parameter depends on the selected parameter. For example, a current output from the battery cell 1 that is too low would indicate significant damage to the material which means that the data representative of current output is greater than a current output threshold if said current output is lower than a threshold indicating significant damage to the material. A value of strain that is too high would also indicate large damage to the material which means that the data representative of strain is greater than a strain threshold if said strain is greater than a threshold indicating significant damage to the material.

If the calculated data representative of the physical parameter is greater than a first threshold (12), then the quantum sensor controller unit 3 send instructions to the battery cell 1 for shutting down (13) by the battery management system 2. This first threshold corresponds to a limit for the corresponding physical parameter above which the battery safety is not ensured.

If the calculated data representative of the physical parameter is lower than a second threshold (14), then the quantum sensor controller unit 3 continues to survey the battery cell 1 and the battery management system 2 continues (15) the operation using the battery cell 1 without interruption. This means that the battery cell 1 safety is ensured and that battery cell 1 in use does not involve risks for its user.

However, if the calculated data representative of the parameter is lower than the first threshold but greater than the second threshold (16), then the quantum sensor controller unit 3 send instructions to the battery management system 2 to take an action to lower said physical parameter in the battery cell 1 below the second threshold (17). For instance, the battery management system 2 control the battery cell 1 to lower the charge/discharge rate of the battery cell 1.

Further to physical parameters instant survey by the quantum sensor controller unit 3, the battery management system 2 also surveys said physical parameters evolution in time. To this end, the steps of providing NV sensors 8 with irradiation 9, measure 10 EPR frequency shift(s) and calculation 11 of the physical parameters of the battery cell 1 are repeated with a defined frequency in order to survey the evolution of said physical parameters in the battery cell 1. The corresponding data are transmitted to the battery management system from the quantum sensor controller unit 3 to be stored in a memory, said memory being included in the battery management system 2 in the present embodiment. Thanks to data stored in memory, the battery management tracks the time relative SoH of the battery cell 1 as explained above.

In this embodiment, the battery management system 2 calculates a rate of change of said physical parameters. Similarly to physical parameters instant survey thanks to the quantum sensor controller unit 3, if the calculated rate of change of said physical parameters exceed a third threshold (19), then the battery management system 2 also takes an action to lower said physical parameter below the third threshold (20).

In the embodiments shown on figures 1 and 2, the processing unit, which calculates the Electron Paramagnetic Resonance (EPR) frequency shift(s) and sends instructions to the battery management 2, is included in the quantum sensor controller unit 3. However, such processing unit could be included in the battery management system 2, in a separate component or even in a remote element such as for instance in the cloud. Similarly, the memory is described above in the battery management system 2 which calculates the rate of change. However, such memory could be included in the quantum sensor controller unit 3 which could also calculate the rate of change.

Indeed, processors suitable for the execution of the tasks and functions related to the invention comprises, by way of example, both general and special purpose microprocessors, and any one or more appropriate processors of any appropriate kind of digital computer. Generally, a processor will receive instructions and data from a read only memory or a random access memory or both. The essential elements of a computer are a processor for performing instructions and one or more memory devices for storing instructions and data.. Computer readable media suitable for storing computer program instructions and data include all forms of non-Volatile memory, media and memory devices, including by way of example semiconductor memory devices, e.g., EPROM, EEPROM, and flash memory devices; magnetic disks, e.g., internal hard disks or removable disks; magneto optical disks; and CD ROM and DVD-ROM disks. The processor and the memory can be supplemented by, or incorporated in, special purpose logic circuitry.

Figures 3 to 5 show examples of EPR frequency shift measurement of NV sensors 8 caused by external perturbations such as a magnetic field perturbation.

In order to measure magnetic fields and other parameters thanks to NV sensors 8, the ODMR (optically detected magnetic resonance) effect is used. When sweeping a microwave field over the EPR spectra of the NV sensor 8, the fluorescence intensity of the NV sensor 8 reduces as the microwave frequency is resonant with the EPR transitions of the NV sensor 8.

In figure 3, the quantum sensor controller unit 3 controls the laser 5 to provide a continuous illumination 21 to NV sensors 8. On the same time, the quantum sensor controller unit 3 controls the RF source 6 to provide continuous microwaves 22 to NV sensors 8. In other words, the battery physical parameters measurement is conducted through continuous wave spectroscopy. By recording the EPR spectrum and fitting for the center position of the resonance lines, it is possible to use fitting of the EPR transition to determine the magnitude of two slightly different external magnetic fields.

The quantum sensor controller unit 3 control the laser 5 and the RF source 6 to obtain a first optical readout 23 from NV sensors 8. This first optical readout 23 corresponds to an initial state of the battery cell 1. During the survey, the quantum sensor controller unit 3 conducts a plurality of further activations of the laser 5 and the RF source 6 to obtain further optical readouts from NV sensors 8.

However, these optical readouts could be slightly different depending on the physical parameters of the battery cell 1 in the vicinity of the NV sensors. Indeed, figure 3 shows a second optical readout 24 obtained after modification of physical parameters, such as for example magnetic field, temperature, strain or current, in the vicinity of NV sensors. This second optical readout 24 is shifted compared to the first optical readout 23 and this shift 25 can be used to calculate a variation in physical parameters of the battery cell 1, thus providing information needed for determining the SoH of the battery cell 1.

In figure 4, the quantum sensor controller unit 3 uses a pump-probe scheme in which the laser 5 is turned off during the sensing period. The spin of the NV sensor 8 is pumped into mₛ=0 state using a laser pulse 26 and a coherent precession is initiated thanks to a π/2 microwave pulsation 27 generated by the RF source 6. After a period t, a second π/2 microwave pulsation is generated 28 by the RF source 6 to stop the precession. Then, a second laser pulse is generated 29 to obtain the spin state of the NV sensor 8. This sequence is repeated plotting the signal intensity for a series of reproduced oscillations with a frequency equal to the EPR transition frequency yielding the absolute value of the magnetic field.

As for the method explained in view of figure 3, a shift 30 between a first optical readout 31 obtained in the initial state of the battery cell 1 and a second optical readout 32 obtained after modification of the physical parameters in the battery cell 1 can be used to calculate the SoH of the battery cell 1. This second calculation method provides more sensitive results than the continuous wave spectroscopy and very long coherent evolution time can be achieved.

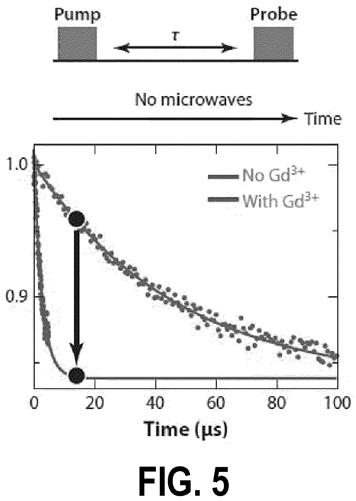

A third calculation method is based on magnetic resonance relaxometry. Magnetic resonance relaxometry makes use of the fact that spin relaxation times directly reflect the amount of magnetic noise occurring at the spin transition frequency. Figure 5 illustrates the principle of relaxometry by exposing an NV center 8 embedded in a nanocrystal to paramagnetic Gd3+ ions. As for the second method, the quantum sensor controller unit 3 controls the laser 5 in a pump-probe scheme. Measurement of the relaxation time reveals much faster decay in the presence of Gd3+ ions. Indeed, Gd3+ ions generate magnetic noise in the material and the effect on the relaxation time is similar to what would be observed in the material (degradation etc...). In the battery, magnetic noise/background will be generated by the active material of the battery. In this case, change in the relaxation time will indicate change in the magnetic field strength of the material, which can represent a change in strain, current, temperature or other parameters. The fast relaxation is caused by the gigahertz fluctuations of the Gd spin, which cause strong magnetic noise at the NV center EPR frequency. The spin relaxation time shift is representative of the magnetic field and other physical parameters in the battery cell 1 and can therefore be used to calculate the SoH of the battery cell 1. Moreover, measurement of the relaxation time using the pump-probe scheme does not require microwave excitation, providing an easy way to calculate SoH.

Although the present disclosure refers to specific exemplary embodiments, modifications may be provided to these examples without departing from the general scope of the invention as defined by the claims. In particular, individual characteristics of the different illustrated/mentioned embodiments may be combined in additional embodiments. Therefore, the description and the drawings should be considered in an illustrative rather than in a restrictive sense.

## Claims

1. A monitoring device for monitoring a battery cell comprising:
- at least one quantum sensor (8) configured to be arranged in a battery cell (1),
- an irradiation source (5, 6, 7) configured to provide excitation to the at least one quantum sensor (8),
- an optical detector (4) configured to receive irradiation emitted by the at least one quantum sensor (8) in reaction to said excitation,
- a Quantum Sensor Controller unit (3) configured to control the irradiation source (5, 6, 7) and measure an Electron Paramagnetic Resonance frequency shift of the at least one quantum sensor (8) as a function of the irradiation received by the optical detector (4),
- a processing unit configured to calculate data representative of at least one physical parameter of the battery cell (1) as a function of the measured Electron Paramagnetic Resonance frequency shift, the processing unit being further configured to calculate a State Of Health of the battery cell (1) as a function of said data representative of at least one physical parameter of the battery cell (1).

2. A monitoring device according to claim 1, wherein the source of irradiation comprises a laser (5), said laser (5) being configured to illuminate the at least one quantum sensor (8).

3. A monitoring device according to claim 1 or 2, wherein the source of irradiation comprises a Radiofrequency source (6), said Radiofrequency source (6) being configured to irradiate the at least one quantum sensor (8) with microwaves.

4. A monitoring device according to any of claims 1 to 3, wherein the at least one quantum sensor (8) comprises a Nitrogen Vacancy center diamond.

5. A monitoring device according to any of claims 1 to 4, wherein the sensor control unit (3) is configured to activate the source of irradiation (5, 6, 7) with a defined frequency.

6. A monitoring device according to claim 5, further comprising a memory configured to store data calculated by the processing unit for each activation of the source of irradiation (5, 6, 7).

7. A monitoring device according to claim 6, wherein the processing unit is configured to calculate a rate of change of the at least one physical parameter as a function said stored data, the processing unit being configured to compare (19) said rate of change to a rate of change threshold and change (20) a using parameter of the battery to lower the rate of change below the rate of change threshold if the said rate of change is greater than the rate of change threshold.

8. A monitoring device according to any of claims 1 to 7, wherein the processing unit is configured to compare (12) the data representative of at least one physical parameter of the battery cell (1) with a parameter threshold and to shut down (12) the battery cell (1) if said data representative of at least one physical parameter is greater than said parameter threshold.

9. A monitoring device according to claim 8, wherein the parameter threshold is a first parameter threshold, the processing unit being configured to compare (16) the data representative of at least one physical parameter of the battery cell to a second parameter threshold, the processing unit being configured to change a usage parameter (17) of the battery cell (1) to lower the data representative of at least one physical parameter below the second parameter threshold if the data representative of at least one physical parameter is greater than said second parameter threshold.

10. A battery cell (1) comprising a monitoring device according to any of claims 1 to 9.

11. A method for monitoring a battery cell, the method comprising:
- irradiating (9) at least one quantum sensor (8) arranged in the battery cell (1) so as to provide excitation of said at least one quantum sensor (8);
- receiving irradiation emitted by the at least one quantum sensor (8) resulting from the irradiation of said quantum sensor (8);
- measuring (10) an Electron Paramagnetic Resonance frequency shift of the at least one quantum sensor (8);
- calculating (11) data representative of at least one physical parameter of the battery cell as a function of the measured Electron Paramagnetic Resonance frequency shift;
- calculate State Of Health of the battery cell as a function of said data representative of at least one physical parameter of the battery cell.

12. A method for monitoring a battery cell according to claim 11 further comprising:
- repeating with a defined frequency the irradiating step (9), the receiving step (10) the measuring step and the calculating step (11).

13. A method for monitoring a battery cell according to claim 12 further comprising:
- storing in a memory a plurality of calculated data representative of at least one physical parameter of the battery cell (1);
- calculating a rate of change of said at least one physical parameter as a function of the calculated data representative of at least one physical parameter and the stored data;
- changing (20) a usage parameter of the battery cell to lower the rate of change below a rate of change threshold if the said rate of change is greater than the rate of change threshold.

14. A method for monitoring a battery cell according to any of claims 11 to 13 further comprising:
- comparing (12) the data representative of at least one physical parameter to a first parameter threshold;
- shutting down (13) the battery cell (1) if said data representative of at least one physical parameter is greater than said parameter threshold.

15. A method for monitoring a battery cell according to any of claims 11 to 14 further comprising:
- comparing (16) the data representative of at least one physical parameter to a second parameter threshold;
- changing (17) a using parameter of the battery cell to lower the data representative of at least one physical parameter below the second parameter threshold if the data representative of at least one physical parameter is greater than said second parameter threshold.

## Amended claims

### Amended claims in accordance with Rule 137(2) EPC.

1. A monitoring device for monitoring a battery cell comprising:
- at least one quantum sensor (8) configured to be arranged in a battery cell (1),
- an irradiation source (5, 6, 7) configured to provide excitation to the at least one quantum sensor (8),
- an optical detector (4) configured to receive irradiation emitted by the at least one quantum sensor (8) in reaction to said excitation,
- a Quantum Sensor Controller unit (3) configured to control the irradiation source (5, 6, 7) and measure an Electron Paramagnetic Resonance frequency shift of the at least one quantum sensor (8) as a function of the irradiation received by the optical detector (4),
- a processing unit configured to calculate data representative of at least one physical parameter of the battery cell (1) as a function of the measured Electron Paramagnetic Resonance frequency shift, the processing unit being further configured to calculate a State Of Health of the battery cell (1) as a function of said data representative of at least one physical parameter of the battery cell (1),
**characterized in that** the processing unit is configured to compare (12) the data representative of at least one physical parameter of the battery cell (1) with a first parameter threshold and to shut down (12) the battery cell (1) if said data representative of at least one physical parameter is greater than said first parameter threshold,
and **in that** the processing unit is configured to compare (16) the data representative of at least one physical parameter of the battery cell to a second parameter threshold, the processing unit being configured to change a usage parameter (17) that is the second parameter threshold of the battery cell (1) to lower the data representative of at least one physical parameter below the second parameter threshold if the data representative of at least one physical parameter is greater than said second parameter threshold.

2. A monitoring device according to claim 1, wherein the source of irradiation comprises a laser (5), said laser (5) being configured to illuminate the at least one quantum sensor (8).

3. A monitoring device according to claim 1 or 2, wherein the source of irradiation comprises a Radiofrequency source (6), said Radiofrequency source (6) being configured to irradiate the at least one quantum sensor (8) with microwaves.

4. A monitoring device according to any of claims 1 to 3, wherein the at least one quantum sensor (8) comprises a Nitrogen Vacancy center diamond.

5. A monitoring device according to any of claims 1 to 4, wherein the sensor control unit (3) is configured to activate the source of irradiation (5, 6, 7) with a defined frequency.

6. A monitoring device according to claim 5, further comprising a memory configured to store data calculated by the processing unit for each activation of the source of irradiation (5, 6, 7).

7. A monitoring device according to claim 6, wherein the processing unit is configured to calculate a rate of change of the at least one physical parameter as a function said stored data, the processing unit being configured to compare (19) said rate of change to a rate of change threshold and change (20) a using parameter of the battery to lower the rate of change below the rate of change threshold if the said rate of change is greater than the rate of change threshold.

8. A battery cell (1) comprising a monitoring device according to any of claims 1 to 7.

9. A method for monitoring a battery cell, the method comprising:
- irradiating (9) at least one quantum sensor (8) arranged in the battery cell (1) so as to provide excitation of said at least one quantum sensor (8);
- receiving irradiation emitted by the at least one quantum sensor (8) resulting from the irradiation of said quantum sensor (8);
- measuring (10) an Electron Paramagnetic Resonance frequency shift of the at least one quantum sensor (8);
- calculating (11) data representative of at least one physical parameter of the battery cell as a function of the measured Electron Paramagnetic Resonance frequency shift;
- calculate State Of Health of the battery cell as a function of said data representative of at least one physical parameter of the battery cell,
**characterized in that** the method further comprises:
- comparing (12) the data representative of at least one physical parameter to a first parameter threshold;
- shutting down (13) the battery cell (1) if said data representative of at least one physical parameter is greater than said parameter threshold, and
- comparing (16) the data representative of at least one physical parameter to a second parameter threshold;
- changing (17) a using parameter that is the second parameter threshold of the battery cell to lower the data representative of at least one physical parameter below the second parameter threshold if the data representative of at least one physical parameter is greater than said second parameter threshold

10. A method for monitoring a battery cell according to claim 9 further comprising:
- repeating with a defined frequency the irradiating step (9), the receiving step (10) the measuring step and the calculating step (11).

11. A method for monitoring a battery cell according to claim 10 further comprising:
- storing in a memory a plurality of calculated data representative of at least one physical parameter of the battery cell (1);
- calculating a rate of change of said at least one physical parameter as a function of the calculated data representative of at least one physical parameter and the stored data;
- changing (20) a usage parameter of the battery cell to lower the rate of change below a rate of change threshold if the said rate of change is greater than the rate of change threshold.
